# EUROPÄISCHE PATENTANMELDUNG

(11) **EP 3 755 132 A1**
(43) Veröffentlichungstag der Anmeldung: **23.12.2020**
(21) Anmeldenummer: 20177977.4
(22) Anmeldetag: 03.06.2020
(51) Int. Cl.: H05K 7/20

(54) **ELEKTRONISCHE ANORDNUNG, HERSTELLUNGSVERFAHREN HIERFÜR UND SCHIENENFAHRZEUG**

(30) Priorität: 21.06.2019 DE 102019209041
(71) Anmelder: Siemens Mobility GmbH, 81739 München (DE)
(72) Erfinder: Schwarzer, Jens Konstantin, 47809 Krefeld (DE)

(57) **Zusammenfassung**

Es wird eine elektronische Anordnung (1) mit zumindest einer elektronischen Komponente (2), einem Luftführungskörper (3) und einem Lüfter (4), der den Luftführungskörper im Betrieb der elektronischen Anordnung mit einer Kühlluft versorgt, angegeben, wobei der Luftführungskörper zumindest einen Luftauslass (31) aufweist, über den der Luftführungskörper die elektronische Komponente mit der Kühlluft kühlt.

Weiterhin werden ein Schienenfahrzeug (9) und ein Verfahren zur Herstellung einer elektronischen Anordnung angegeben.

## Beschreibung

Die vorliegende Anmeldung betrifft eine elektronische Anordnung und ein Schienenfahrzeug mit einer solchen elektronischen Anordnung sowie ein Verfahren zur Herstellung einer elektronischen Anordnung.

Bei der Entwicklung von elektronischen Komponenten können Wärmenester auftreten, deren genaue Position nur schwer vorhersagbar ist. In diesen Wärmenestern kann die zulässige Temperatur im Betrieb überschritten werden, was zum Ausfall von elektronischen Bauteilen führen kann. Das Entfernen derartiger Wärmenester kann insbesondere dadurch erschwert werden, dass diese oftmals nur schwer zugänglich sind.

Eine Aufgabe ist es, die Gefahr einer Schädigung durch auftretende Wärmenester zu minimieren.

Diese Aufgabe wird durch eine elektronische Anordnung und ein Verfahren zur Herstellung einer elektronischen Anordnung gemäß den unabhängigen Patentansprüchen gelöst. Weitere Ausgestaltungen und Zweckmäßigkeiten sind Gegenstand der abhängigen Patentansprüche.

Es wird eine elektronische Anordnung angegeben. Nachfolgend im Zusammenhang mit zumindest einer Ausführungsform der elektronischen Anordnung angeführte Merkmale sind mit anderen im Zusammenhang mit zumindest einer Ausführungsform genannten Merkmalen und/oder mit Merkmalen aus den Ausführungsbeispielen kombinierbar, solange sich diese Merkmale nicht widersprechen oder explizit anderes angegeben ist.

Gemäß zumindest einer Ausführungsform der elektronischen Anordnung weist die elektronische Anordnung zumindest eine elektronische Komponente auf. Beispielsweise ist die elektronische Komponente Teil einer elektronischen Schaltung. Zum Beispiel ist die elektronische Komponente ein Kondensator oder eine andere elektronische Komponente, bei der die Gefahr einer Schädigung im Fall eines Überschreitens der zulässigen Betriebstemperatur besteht. Beispielsweise steht die elektronische Komponente oder die gesamte elektronische Schaltung in thermischer Wechselwirkung mit einem aktiven Kühlelement, beispielsweise einem Wärmetauscher mit einem Kühlmedium, und/oder einem passiven Kühlelement, etwa einem Kühlkörper.

Gemäß zumindest einer Ausführungsform der elektronischen Anordnung weist die elektronische Anordnung einen Luftführungskörper auf. Der Luftführungskörper ist insbesondere dafür vorgesehen, die elektronische Komponente im Betrieb der elektronischen Anordnung mit Kühlluft zu versorgen. Zum Beispiel weist der Luftführungskörper eine Längserstreckungsachse auf und erstreckt sich entlang der Längserstreckungsachse zwischen einem ersten Ende und einem zweiten Ende des Luftführungskörpers. Die Ausdehnung des Luftführungskörpers entlang der Längserstreckungsachse ist zweckmäßigerweise groß im Vergleich zur maximalen Ausdehnung senkrecht zur Längserstreckungsachse, beispielsweise mindestens fünfmal so groß oder mindestens zehnmal so groß oder mindestens zwanzigmal so groß.

Gemäß zumindest einer Ausführungsform der elektronischen Anordnung weist die elektronische Anordnung einen Lüfter auf. Der Lüfter ist dafür vorgesehen, den Luftführungskörper im Betrieb der elektronischen Anordnung mit einer Kühlluft zu versorgen. Mit anderen Worten ist der Lüfter mit dem Luftführungskörper gekoppelt und bewirkt eine Luftströmung im Luftführungskörper. Beispielsweise strömt die Luft am ersten Ende des Luftführungskörpers in diesen hinein.

Der Begriff "Lüfter" bezeichnet allgemein eine, insbesondere elektrisch betriebene, Anordnung, über die im Betrieb der elektronischen Anordnung Luft in den Luftführungskörper eingebracht werden kann. Insbesondere bewirkt der Lüfter eine Luftströmung durch den Luftführungskörper, beispielsweise vom ersten Ende in Richtung des zweiten Endes.

Gemäß zumindest einer Ausführungsform der elektronischen Anordnung weist der Luftführungskörper zumindest einen Luftauslass auf. Aus diesem Luftauslass tritt die Kühlluft aus und kühlt die elektronische Komponente. Mit anderen Worten ist über die Position des Luftauslasses festgelegt, an welcher Stelle die Kühlluft aus dem Luftführungskörper strömt.

In mindestens einer Ausführungsform weist die elektronische Anordnung zumindest eine elektronische Komponente, einen Luftführungskörper und einen Lüfter auf, wobei der Lüfter den Luftführungskörper im Betrieb der elektronischen Anordnung mit einer Kühlluft versorgt und der Luftführungskörper zumindest einen Luftauslass aufweist, über den der Luftführungskörper die elektronische Komponente mit der Kühlluft kühlt.

Mittels des Luftführungskörpers wird die elektronische Komponente gezielt mit Kühlluft versorgt. Insbesondere kann die elektronische Komponente auch dann zuverlässig gekühlt werden, wenn die elektronische Komponente aufgrund seiner Positionierung innerhalb der elektronischen Anordnung nicht für eine direkte Kühlung mittels eines in der Nähe der elektronischen Komponente angebrachten Lüfters zugänglich wäre.

Gemäß zumindest einer Ausführungsform der elektronischen Anordnung weist die elektronische Anordnung ein geschlossenes Gehäuse auf. "Geschlossenes Gehäuse" bedeutet in diesem Zusammenhang, dass es zwischen der elektronischen Anordnung und der äußeren Umgebung des Gehäuses keinen oder zumindest keinen für die Kühlung der elektronischen Anordnung relevanten Luftaustausch gibt.

Die Kühlluft stammt also von einem Bereich innerhalb des Gehäuses. Insbesondere ist die Temperatur in diesem Bereich niedriger als in einer Umgebung der elektronischen Komponente, beispielsweise um mindestens 10 °C. Mit anderen Worten versorgt der Lüfter mit dem Luftführungskörper die elektronische Komponente mit Luft aus einem kühleren Bereich innerhalb der elektronischen Anordnung.

Gemäß zumindest einer Ausführungsform der elektronischen Anordnung ist der Luftführungskörper aus einem elektrisch isolierenden Material gebildet. Die Gefahr eines elektrischen Kurzschlusses über den Luftführungskörper kann so vermieden werden. Zudem eignet sich der Luftführungskörper insbesondere auch für elektronische Anordnungen, bei denen höhere Spannungen, insbesondere Spannungen über 200 Volt oder über 300 Volt auftreten. Die Gefahr eines elektrischen Überschlags wird mittels des isolierenden Materials vermieden.

Gemäß zumindest einer Ausführungsform der elektronischen Anordnung weist der Luftführungskörper eine Mehrzahl von Luftauslässen auf. Über die Größe und/oder die Belegungsdichte des Luftführungskörpers mit Luftauslässen ist einstellbar, an welchen Stellen die Kühlluft aus dem Luftführungskörper austritt. Ein oder mehrere Luftauslässe können hierbei zur Kühlung einer oder mehrerer voneinander beabstandeten elektronischen Komponenten vorgesehen sein.

Gemäß zumindest einer Ausführungsform der elektronischen Anordnung ist zumindest ein Luftauslass vom ersten Ende und vom zweiten Ende des Luftführungskörpers beabstandet. Die Kühlluft tritt also seitlich, das heißt schräg oder senkrecht zur Längserstreckungsachse des Luftführungskörpers aus. Bei einer stellenweise gekrümmt verlaufenden Längserstreckungsachse des Luftführungskörpers bezieht sich dies jeweils auf den Verlauf der Längserstreckungsachse an der jeweiligen Position des Luftauslasses.

Gemäß zumindest einer Ausführungsform der elektronischen Anordnung weist der Luftauslass eine Düse auf. Bei mehreren Luftauslässen können auch zwei oder mehr Luftauslässe oder auch alle Luftauslässe eine Düse aufweisen. Mittels einer Düse kann die Zielwirkung der Luftkühlung weiter verstärkt werden.

Gemäß zumindest einer Ausführungsform der elektronischen Anordnung ist der Luftführungskörper biegbar. Beispielsweise ist der Luftführungskörper ein flexibler Schlauch oder ein flexibles Rohr. Die Positionierbarkeit des Luftführungskörpers innerhalb der elektronischen Anordnung ist dadurch vereinfacht.

Gemäß zumindest einer Ausführungsform der elektronischen Anordnung weist der Luftführungskörper einen Querschnitt mit zumindest einem geraden Abschnitt auf. Eine definierte Montage des Luftführungskörpers wird mittels des geraden Abschnitts als Auflagefläche vereinfacht. Beispielsweise weist der Luftführungskörper einen mehreckigen Querschnitt auf.

Gemäß zumindest einer Ausführungsform der elektronischen Anordnung weist der Luftführungskörper einen Querschnitt mit zumindest einem gekrümmten Abschnitt auf. Beispielsweise ist der Querschnitt des Luftführungskörpers rund oder elliptisch. Insbesondere runde Querschnitte sind einfach herstellbar.

Gemäß zumindest einer Ausführungsform der elektronischen Anordnung steht die Kühlluft im Luftführungskörper in thermischem Kontakt zu einem Wärmetauscher. Mittels des Wärmetauschers kann die Temperatur der Kühlluft zusätzlich reduziert werden. Beispielsweise eignet sich für den Wärmetauscher ein Kreuzstromwärmetauscher, auch als Cross Flow Wärmetauscher bezeichnet.

Die beschriebene elektronische Anordnung eignet sich insbesondere für die Verwendung in einem Schienenfahrzeug. Ein Schienenfahrzeug mit einer solchen elektronischen Anordnung zeichnet durch eine besonders hohe Zuverlässigkeit auf.

Bei einem Verfahren zur Herstellung einer elektronischen Anordnung wird gemäß einer Ausführungsform eine elektronische Grundanordnung bereitgestellt. Die elektronische Grundanordnung wird temporär betrieben und zumindest ein Wärmenest ermittelt. Ein Luftführungskörper mit zumindest einem Luftauslass wird derart angeordnet und ausgebildet, dass der Luftführungskörper eine elektronische Komponente in dem Wärmenest im Betrieb der fertiggestellten elektronischen Anordnung mittels eines Lüfters mit Kühlluft versorgt.

Die fertiggestellte elektronische Anordnung weist also die elektronische Grundanordnung und zumindest einen Luftführungskörper, der an einen Lüfter gekoppelt ist, auf. Die elektronische Grundanordnung selbst weist beispielsweise bereits ein aktives und/oder ein passives Kühlelement auf.

Es ist also nicht erforderlich, die Entstehung von Wärmenestern bei der Konstruktion der elektronischen Anordnung vollständig zu vermeiden oder zumindest den gesamten Kühlungsbedarf an jeder Stelle der elektronischen Anordnung vollständig vorherzusehen. Vielmehr kann anhand des tatsächlichen Betriebs der elektronischen Grundanordnung, insbesondere kurz vor Fertigstellung der elektronischen Anordnung, real ermittelt werden, ob sich in der elektronischen Grundanordnung ein Wärmenest oder mehrere Wärmenester bilden. Das Ergebnis einer solchen Ermittlung ist auf nachfolgend herzustellende baugleiche elektronische Anordnungen übertragbar. Alternativ wird beispielsweise jede herzustellende elektronische Anordnung der Ermittlung eines oder mehrerer Wärmenester unterzogen.

Beispielsweise wird das Wärmenest mittels einer Messung der Wärmestrahlung ermittelt. Dies erfolgt zum Beispiel lokal an einer oder mehreren Stellen oder ortsaufgelöst, etwa durch eine Wärmebildkamera.

Gemäß zumindest einer Ausführungsform des Verfahrens wird der zumindest eine Luftauslass im Luftführungskörper in Kenntnis der ermittelten Position des Wärmenests ausgebildet. Mit anderen Worten wird anhand der Lage des Wärmenests festgelegt, an welcher Position im Luftführungskörper ein Luftauslass oder mehrere Luftauslässe erforderlich sind. Dadurch kann auf einfache und kostengünstige Weise die Gefahr einer Schädigung von elektronischen Komponenten minimiert werden. Insbesondere ist es nicht erforderlich, die Architektur der elektronischen Grundanordnung zu überarbeiten oder zusätzliche Wärmetauscher vorzusehen.

Im einfachsten Fall wird für den Luftauslass im Luftführungskörper ein Loch ausgebildet.

Das beschriebene Verfahren ist zur Herstellung einer weiter oben beschriebenen elektronischen Anordnung besonders geeignet. Im Zusammenhang mit der elektronischen Anordnung beschriebene Merkmale können daher auch für das Verfahren herangezogen werden und umgekehrt.

Die oben genannten Eigenschaften, Merkmale und Vorteile der Erfindung und die Art und Weise, wie diese erreicht werden, werden durch die folgende Beschreibung der Ausführungsbeispiele der Erfindung in Verbindung mit den entsprechenden Figuren weitergehend erläutert, wobei
Figur 1 ein Ausführungsbeispiel für eine elektronische Anordnung zeigt;
Figur 2 ein Ausführungsbeispiel für einen Luftführungskörper zeigt;
Figur 3 einen Ausschnitt eines Luftführungskörpers gemäß einem Ausführungsbeispiel zeigt;
Die Figuren 4 und 5 jeweils einen Querschnitt eines Ausführungsbeispiels eines Luftführungskörpers zeigen;
Figur 6 ein Schienenfahrzeug mit einer elektronischen Anordnung zeigt; und die
Figuren 7 bis 9 ein Ausführungsbeispiel für ein Verfahren zur Herstellung einer elektronischen Anordnung anhand von schematisch dargestellten Zwischenschritten zeigen.

Die Figuren sind jeweils schematische Darstellungen und daher nicht maßstabsgetreu. Insbesondere können verschiedene Elemente zur verbesserten Darstellung oder zum verbesserten Verständnis übertrieben groß dargestellt sein.

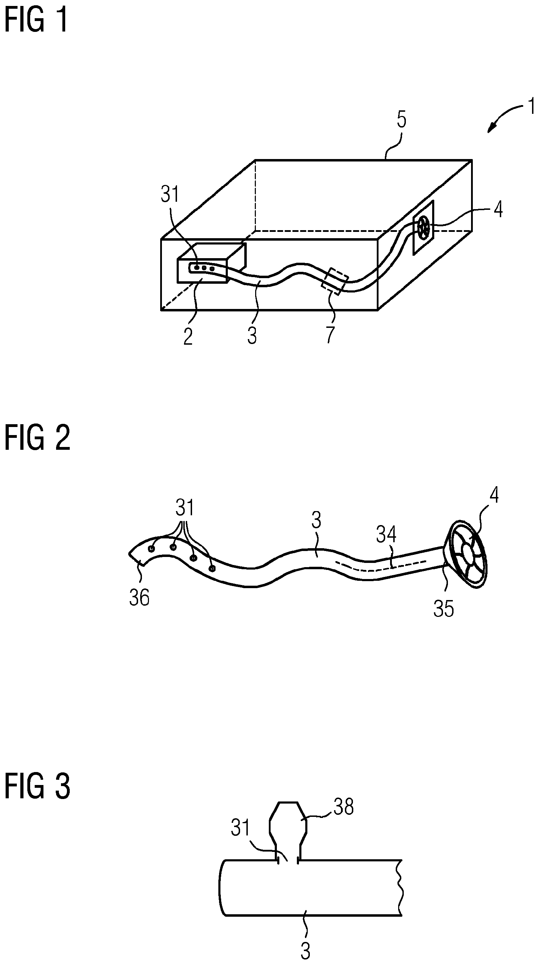

In Figur 1 ist ein Ausführungsbeispiel für eine elektronische Anordnung in perspektivischer Ansicht dargestellt, wobei die elektronische Anordnung zur verbesserten Darstellbarkeit stark vereinfacht dargestellt ist.

Die elektronische Anordnung 1 weist eine elektronische Komponente 2 auf. Beispielsweise ist die elektronische Komponente 2 ein Kondensator oder ein anderes hitzeempfindliches Bauelement.

Beispielsweise ist die elektronische Komponente 2 Teil einer elektronischen Schaltung mit einer Vielzahl von weiteren Komponenten. Die elektronische Schaltung ist zur verbesserten Darstellbarkeit nicht explizit gezeigt. Weiterhin wird die elektronische Schaltung typischerweise über ein aktives oder passives Kühlelement gekühlt. Dieses ist zur vereinfachten Darstellung ebenfalls nicht explizit gezeigt.

Die elektronische Anordnung 1 weist weiterhin einen Luftführungskörper 3 und einen Lüfter 4 auf, wobei der Lüfter 4 den Luftführungskörper im Betrieb der elektronischen Anordnung 1 mit einer Kühlluft versorgt. Die Kühlluft tritt durch zumindest einen Luftauslass 31 des Luftführungskörpers aus und kühlt die elektronische Komponente 2.

Die elektronische Anordnung 1 weist weiterhin ein geschlossenes Gehäuse 5 auf. Die Kühlluft stammt aus einem Bereich innerhalb des Gehäuses 5, in dem die Temperatur niedriger ist als in einer Umgebung der elektronischen Komponente 2, beispielsweise um mindestens 10 °C. Die Kühlluft wird also nicht aus der Umgebung angesaugt. Dadurch eignet sich die elektronische Anordnung beispielsweise auch in Umgebungen mit hoher Staubbelastung.

Optional weist die elektronische Anordnung einen Wärmetauscher 7 auf, welcher mit der Kühlluft im Luftführungskörper 2 in thermischem Kontakt steht. Die Kühlluft wird also auf dem Weg vom Lüfter 4 in Richtung der elektronischen Komponente 2 weiter abgekühlt, sodass sich die Kühlwirkung für die elektronische Komponente 2 erhöht.

In dem gezeigten Ausführungsbeispiel ist der Luftführungskörper ein flexibler Schlauch oder ein flexibles Rohr. Weiterhin ist der Luftführungskörper aus einem elektrisch isolierenden Material gebildet, sodass der Luftführungskörper vergleichsweise einfach von dem Lüfter 4 zu der elektronischen Komponente 2 verlegt werden kann, ohne dass die Gefahr eines elektrischen Kurzschlusses oder eines elektrischen Überschlags erhöht wird. Insbesondere kann die elektronische Komponente 2 auch dann zuverlässig mit Kühlluft versorgt werden, wenn diese innerhalb des Gehäuses 5 so verbaut ist, dass sie für eine anderweitige Kühlung, etwa einen in der elektronischen Komponente platzierten Lüfter, nicht oder nur mit viel Aufwand zugänglich wäre.

Weiterhin ist die Positionierung des Lüfters 4 weitgehend unabhängig von der Position, an der die Kühlluft erforderlich ist, also unabhängig von der Position des auftretenden Wärmenests. Der Lüfter ist insbesondere an einer Stelle innerhalb des Gehäuses positionierbar, an der die Luft eine vergleichsweise niedrige Temperatur hat.

In Figur 2 ist ein Ausführungsbeispiel für einen Luftführungskörper 3 mit einem Lüfter 4 gezeigt. Der Luftführungskörper 3 erstreckt sich zwischen einem ersten Ende 35 und einem zweiten Ende 36 entlang einer Längserstreckungsachse 34.

Der Lüfter 4 ist an den Luftführungskörper 3 gekoppelt, sodass die Luft am ersten Ende 35 in den Luftführungskörper einströmt und durch die Luftauslässe 31 austritt.

Der Luftführungskörper 3 weist exemplarisch vier Luftauslässe 31 auf, wobei die Luftauslässe jeweils vom ersten Ende 35 und vom zweiten Ende 36 beabstandet sind. Position, Anzahl und Größe der Luftauslässe 31 sind hierbei während der Herstellung in weiten Grenzen variierbar und an die jeweiligen Anforderungen der Kühlung anpassbar.

Zur Verstärkung der Zielwirkung der Luftströmung kann zumindest ein Luftauslass 31, wie in Figur 3 gezeigt, mit einer Düse 38 versehen sein. Selbstverständlich können auch mehrere oder auch alle Luftauslässe eine solche Düse aufweisen.

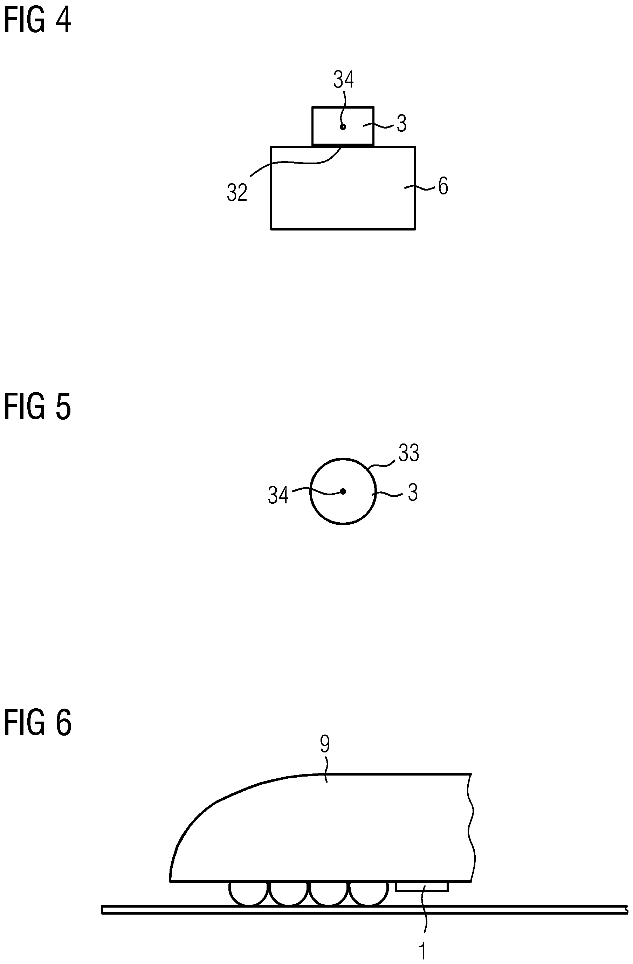

In dem in Figur 4 dargestellten Ausführungsbeispiel weist der Luftführungskörper 3 zumindest einen geraden Abschnitt 32 im Querschnitt auf. Der gerade Abschnitt 32 ist einer Trägerplatte 6 zugewandt. Die Trägerplatte 6 ist beispielsweise ein Teil des Gehäuses, eine Leiterplatte oder ein anderes Element der elektronischen Anordnung. Die definierte Montage des Luftführungskörpers wird dadurch vereinfacht.

Alternativ kann der Luftführungskörper 3, wie in Figur 5 dargestellt, auch im Querschnitt einen gekrümmten Abschnitt 33 aufweisen und insbesondere rund oder elliptisch ausgebildet sein.

In Figur 6 ist ein Ausführungsbeispiel eines Schienenfahrzeugs 9 mit einer elektronischen Anordnung 1 gezeigt. Beispielsweise ist das Schienenfahrzeug ein Zug oder ein Triebwagen. Mit dem geschlossenen Gehäuse ist die elektronische Anordnung 1 auch an Stellen des Schienenfahrzeugs 9 montierbar, an denen eine vergleichsweise hohe Staubbelastung auftritt, beispielsweise am Boden des Schienenfahrzeugs.

Generell eignet sich die beschriebene Kühlung mittels eines Luftführungskörpers für alle Arten von elektronischen Anordnungen, bei denen die Gefahr einer Schädigung von elektronischen Komponenten aufgrund von lokalen Wärmenestern besteht, insbesondere bei komplexen elektronischen Anordnungen, bei denen die Position solcher Wärmenester nicht ohne Weiteres vorhersagbar ist und/oder bei denen die Wärmenester aufgrund einer kompakten Ausgestaltung der elektronischen Anordnung für konventionelle Kühler nicht ohne Weiteres zugänglich sind.

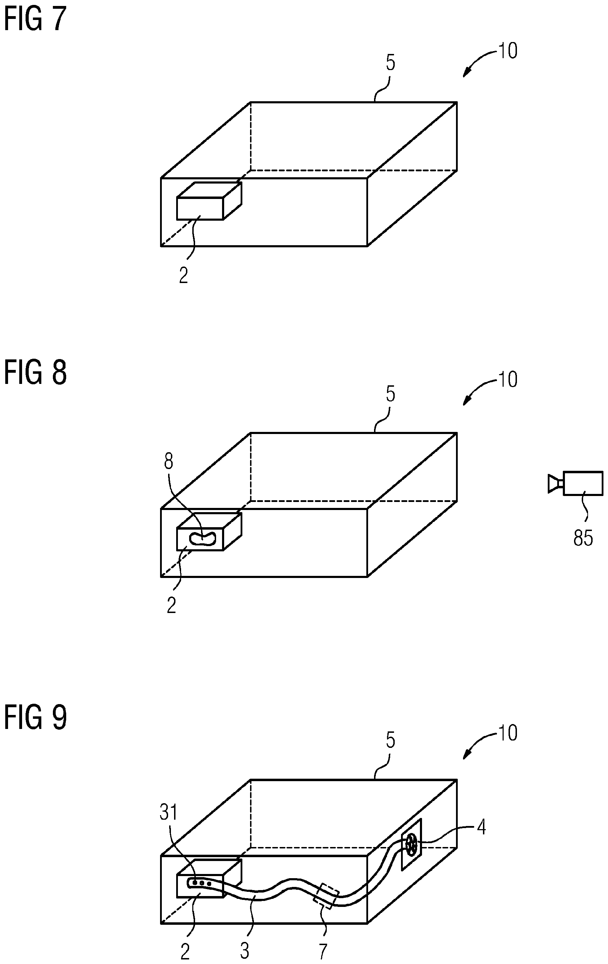

In den Figuren 7 bis 9 ist ein Ausführungsbeispiel für ein Verfahren zur Herstellung einer elektronischen Anordnung gezeigt, wobei das Verfahren exemplarisch für eine elektronische Anordnung beschrieben wird, wie sie im Zusammenhang mit Figur 1 ausgebildet ist.

Wie in Figur 7 gezeigt, wird eine elektronische Grundanordnung 10 bereitgestellt. Diese elektronische Grundordnung entspricht weitgehend der fertiggestellten elektronischen Anordnung 1, jedoch ohne den vollständigen Kühlmechanismus.

Die elektronische Grundanordnung 10 wird temporär betrieben (Figur 8). Im Betrieb wird ermittelt, ob und wenn ja, an welcher Stelle ein Wärmenest oder mehrere Wärmenester auftreten. In dem gezeigten Ausführungsbeispiel wird exemplarisch ein Wärmenest 8 ermittelt, beispielsweise mittels einer Wärmebildkamera 85.

Anhand der ermittelten Position des Wärmenests 8 wird nun der Luftführungskörper so ausgebildet und in der herzustellenden elektronischen Anordnung 1 positioniert, dass eine sich im Wärmenest befindliche elektronische Komponente 2 mittels des Luftführungskörpers 3 in Verbindung mit einem Lüfter 4 mit Kühlluft versorgt wird.

Figur 9 zeigt die fertiggestellte elektronische Anordnung 1. Diese elektronische Anordnung zeichnet sich durch eine besonders hohe Zuverlässigkeit aus, da die im Betrieb erforderliche Kühlung der elektronischen Anordnung anhand eines realen Betriebs ermittelt und angepasst werden kann.

Obwohl die Erfindung anhand von Ausführungsbeispielen detailliert dargestellt und beschrieben wurde, ist die Erfindung nicht auf die offenbarten Ausführungsbeispiele und die darin erläuterten konkreten Merkmalskombinationen beschränkt. Weitere Variationen der Erfindung können von einem Fachmann erhalten werden, ohne den Schutzumfang der beanspruchten Erfindung zu verlassen.

### Bezugszeichenliste

- 1: elektronische Anordnung
- 10: elektronische Grundanordnung
- 2: elektronische Komponente
- 3: Luftführungskörper
- 31: Luftauslass
- 32: gerader Abschnitt
- 33: gekrümmter Abschnitt
- 34: Längserstreckungsachse
- 35: erstes Ende
- 36: zweites Ende
- 38: Düse
- 4: Lüfter
- 5: Gehäuse
- 6: Trägerplatte
- 7: Wärmetauscher
- 8: Wärmenest
- 85: Wärmebildkamera
- 9: Schienenfahrzeug

## Patentansprüche

1. Elektronische Anordnung (1) mit
- zumindest einer elektronischen Komponente (2);
- einem Luftführungskörper (3); und
- einem Lüfter (4), der den Luftführungskörper im Betrieb der elektronischen Anordnung mit einer Kühlluft versorgt;
wobei der Luftführungskörper zumindest einen Luftauslass (31) aufweist, über den der Luftführungskörper die elektronische Komponente mit der Kühlluft kühlt.

2. Elektronische Anordnung nach Anspruch 1,
wobei die elektronische Anordnung ein geschlossenes Gehäuse (5) aufweist und die Kühlluft von einem Bereich innerhalb des Gehäuses stammt.

3. Elektronische Anordnung nach einem der vorherigen Ansprüche,
wobei der Luftführungskörper aus einem elektrisch isolierenden Material gebildet ist.

4. Elektronische Anordnung nach einem der vorherigen Ansprüche,
wobei sich der Luftführungskörper entlang einer Längserstreckungsachse (34) zwischen einem ersten Ende (35) und einem zweiten Ende (36) erstreckt und der Luftauslass vom ersten Ende und vom zweiten Ende beabstandet ist.

5. Elektronische Anordnung nach einem der vorherigen Ansprüche,
wobei der Luftauslass eine Düse (38) aufweist.

6. Elektronische Anordnung nach einem der vorherigen Ansprüche,
wobei der Luftführungskörper eine Mehrzahl von Luftauslässen aufweist.

7. Elektronische Anordnung nach einem der vorherigen Ansprüche,
wobei der Luftführungskörper biegbar ist.

8. Elektronische Anordnung nach einem der vorherigen Ansprüche,
wobei der Luftführungskörper einen Querschnitt mit zumindest einem geraden Abschnitt (32) aufweist.

9. Elektronische Anordnung nach einem der vorherigen Ansprüche,
wobei der Luftführungskörper einen Querschnitt mit zumindest einem gekrümmten Abschnitt (33) aufweist.

10. Elektronische Anordnung nach einem der vorherigen Ansprüche,
wobei die Kühlluft im Luftführungskörper in thermischem Kontakt zu einem Wärmetauscher (7) steht.

11. Schienenfahrzeug (9) mit einer elektronischen Anordnung (1) nach einem der vorherigen Ansprüche.

12. Verfahren zur Herstellung einer elektronischen Anordnung mit den Schritten:
a) Bereitstellen einer elektronischen Grundanordnung (10);
b) temporäres Betreiben der elektronischen Grundanordnung und Ermitteln von zumindest einem Wärmenest (8);
c) Anordnen und Ausbilden eines Luftführungskörpers (3) mit zumindest einem Luftauslass (31) derart, dass der Luftführungskörper eine elektronische Komponente (2) in dem Wärmenest im Betrieb der fertig gestellten elektronischen Anordnung mittels eines Lüfters (3) mit Kühlluft versorgt.

13. Verfahren nach Anspruch 12,
wobei der zumindest eine Luftauslass im Luftführungskörper in Kenntnis der ermittelten Position des Wärmenests ausgebildet wird.
